# EUROPEAN PATENT APPLICATION

(11) **EP 4 701 061 A1**
(43) Date of publication of application: **25.02.2026**
(21) Application number: 25740996.1
(22) Date of filing: 22.05.2025
(51) Int. Cl.: H02M 7/48, H01L 23/40, H01L 23/473

(54) **ELECTRICAL COMPONENT MODULE, REFRIGERATION CYCLE DEVICE, AND METHOD FOR MANUFACTURING ELECTRICAL COMPONENT MODULE**

(30) Priority: 12.07.2024 JP 2024112835
(71) Applicant: DAIKIN INDUSTRIES, LTD., Osaka 530-0001 (JP)
(72) Inventor: FUJIWARA, Masahide, Osaka-shi, Osaka 530-8323 (JP); NAKATSUJI, Yosuke, Osaka-shi, Osaka 530-8323 (JP); ITOU, Taku, Osaka-shi, Osaka 530-8323 (JP); SUZUKI, Ayato, Osaka-shi, Osaka 530-8323 (JP); OSHITA, Kazuhiro, Osaka-shi, Osaka 530-8323 (JP); HIRAOKA, Nobuyasu, Osaka-shi, Osaka 530-8323 (JP); OGATA, Yuji, Osaka-shi, Osaka 530-8323 (JP); MORITA, Kohei, Osaka-shi, Osaka 530-8323 (JP)
(74) Representative: Hoffmann Eitle
(86) International application number: PCT/JP2025/018487
(87) International publication number: WO 2026/014078

(57) **Abstract**

An electric component module (100) includes a first heat-generating component (130a), a substrate (110), a heat sink (140), a first member (120), and a screw (160). The substrate (110) has a mounting surface (111) on which the first heat-generating component (130a) is mounted. The heat sink (140) is thermally connected to the first heat-generating component (130a). The heat sink (140) has a screw hole (143) penetrating in the thickness direction. The first member (120) is disposed between the mounting surface (111) and the heat sink (140) and fixed to the mounting surface (111). The first member (120) has a screw receiver (123). The screw (160) is inserted into the screw hole (143) from an upper surface (141) on the opposite side to a lower surface (142) of the heat sink (140) facing the mounting surface (111), and is fixed to the first member (120).

## Description

### TECHNICAL FIELD

The present invention relates to an electric component module, a refrigeration cycle apparatus, and a method for manufacturing the electric component module.

### BACKGROUND ART

A heat-generating component such as a power module that handles a large current in a device generates heat during use and reaches a high temperature. In order to prevent damage due to an excessive temperature rise, such a heat-generating component is often used in combination with a heat-dissipating component such as a heat sink or a refrigerant jacket. The heat generated by the heat-generating component is transferred to the heat-dissipating component that is in direct or indirect contact with the heat-generating component, and then released to a relatively low temperature region such as the atmosphere or a fluid refrigerant.

In order to efficiently cool the heat-generating component, it is necessary to improve heat conduction between the heat-generating component and the heat-dissipating component. For example, in Patent Literature 1 (WO 2009/150804 A), a power element (heat-generating component) and a heat transfer plate (heat-dissipating component) are fixed to each other with screws passing through from the power element side, thereby appropriately connecting the refrigerant jacket and the power element.

### SUMMARY OF THE INVENTION

### <Technical Problem>

Equipment maintenance operations often involve removal or replacement of heat-generating components and heat-dissipating components. However, the electric component module disclosed in Patent Literature 1 has a screw head at a position facing a substrate in a state where the heat-generating component and the heat-dissipating component are mounted on the substrate. Therefore, it is necessary to provide a threaded hole for maintenance work on the substrate in advance.

### <Solution to Problem>

An electric component module according to a first aspect includes a first heat-generating component, a substrate, a heat sink, a first member, and a screw. The first heat-generating component has a first body part and a lead extending from the first body part. The substrate has a mounting surface on which the first heat-generating component is mounted. The heat sink is thermally connected to the first heat-generating component. In addition, the heat sink has a screw hole penetrating in the thickness direction. The first member is disposed between the mounting surface and the heat sink and fixed to the mounting surface. In addition, the first member has a screw receiver. The screw is inserted into the screw hole from a surface on the opposite side to a surface of the heat sink facing the mounting surface, and is fixed to the first member.

The electric component module according to the first aspect eliminates the need for a threaded hole in the substrate.

An electric component module according to a second aspect is the electric component module according to the first aspect, in which the substrate has a first hole penetrating in the thickness direction. The first member has a positioner for positioning the first member with respect to the mounting surface. The positioner is inserted into the first hole.

With the electric component module according to the second aspect, the first member can be positioned with respect to the substrate.

An electric component module according to a third aspect is the electric component module according to the second aspect, in which the first hole has a diameter smaller than a diameter of a threaded hole of the screw receiver.

The electric component module according to the third aspect eliminates the need for a large hole in the substrate.

An electric component module according to a fourth aspect is the electric component module according to the first or second aspect, in which the first member further has a nut serving as a component of the screw receiver.

With the electric component module according to the fourth aspect, the screw can be fixed to the nut.

An electric component module according to a fifth aspect is the electric component module according to the fourth aspect, in which the first member further has a recess in a first surface facing the heat sink, the recess being configured to accommodate the nut.

The electric component module according to the fifth aspect can stabilize the placement position of the nut.

An electric component module according to a sixth aspect is the electric component module according to any one of the first to fifth aspects, and further includes a second heat-generating component mounted on the mounting surface. The second heat-generating component has a second body part having a height different from the first body part, and a lead extending from the second body part. The first member includes an eleventh member and a twelfth member having different heights. The first body part is supported by the eleventh member and the second body part is supported by the twelfth member, so that the surfaces, facing the heat sink, of the first heat-generating component and the second heat-generating component mounted on the mounting surface are positionally aligned.

With the electric component module according to the sixth aspect, the cooling performance of the heat sink for the heat-generating components having different sizes can be improved.

An electric component module according to a seventh aspect is the electric component module according to any one of the first to sixth aspects, in which a plurality of the first members are integrally molded.

The electric component module according to the seventh aspect facilitates the arrangement of the plurality of first members.

A refrigeration cycle apparatus according to an eighth aspect includes a refrigerant pipe through which a refrigerant flows, and the electric component module according to any one of the first to seventh aspects. The refrigerant pipe is in contact with the heat sink.

The refrigeration cycle apparatus according to the eighth aspect eliminates the need for a threaded hole in the substrate of the electric component module.

A refrigeration cycle apparatus according to a ninth aspect is the refrigeration cycle apparatus according to the eighth aspect, in which the heat sink has a second hole that allows passage of the refrigerant pipe. The refrigerant pipe extending through the second hole is joined to the heat sink.

The refrigeration cycle apparatus according to the ninth aspect improves the cooling performance of the heat sink for the electric component module.

A method for manufacturing an electric component module according to a tenth aspect includes a first step, a second step, a third step, and a fourth step. A first heat-generating component has a first body part and a lead extending from the first body part. A substrate has a mounting surface on which the first heat-generating component is mounted. In the first step, a first member having a screw receiver is placed on the mounting surface. In the second step, the first heat-generating component is mounted on the mounting surface. In the third step, a heat sink having a screw hole penetrating in the thickness direction is placed so as to be thermally connected to the first heat-generating component. In the fourth step, a screw is inserted into the screw hole from a surface on the opposite side to a surface of the heat sink facing the mounting surface, and is fixed to the first member.

The method for manufacturing an electric component module according to the tenth aspect eliminates the need for a threaded hole in the substrate.

### BRIEF DESCRIPTION OF THE DRAWINGS

FIG. 1 is a schematic view of an electric component module according to a first embodiment.
FIG. 2 is a sectional view taken along line A-A' in FIG. 1.
FIG. 3 is a sectional view of a first member of the electric component module in FIG. 1.
FIG. 4 is a flowchart illustrating a method for manufacturing the electric component module in FIG. 1.
FIG. 5 is an explanatory diagram of an electric component module according to Modification 1F.
FIG. 6 is an explanatory diagram of an electric component module according to Modification 1G.
FIG. 7 is a schematic view of an integrally molded first member according to Modification 1H.
FIG. 8 is an explanatory diagram of an electric component module according to Modification 1J.
FIG. 9 is a schematic configuration diagram of an air conditioner according to a second embodiment.
FIG. 10 is a schematic view of an electric component module according to the second embodiment.
FIG. 11 is a sectional view taken along line B-B' in FIG. 10.
FIG. 12 is a sectional view taken along line C-C' in FIG. 10.
FIG. 13 is an explanatory diagram of an electric component module according to Modification 2A.
FIG. 14 is an explanatory diagram of an electric component module according to Modification 2B.

### DESCRIPTION OF EMBODIMENTS

### <First Embodiment>

An electric component module 100 and a method for manufacturing the electric component module 100 according to an embodiment of the present disclosure will be described with reference to the drawings. Note that in the following description, for convenience of explanation, expressions such as up, down, left, and right may be used to describe directions and positional relationships. The directions indicated by these expressions follow the directions indicated by the arrows in the drawings.

### (1) Overall Configuration of Electric Component Module

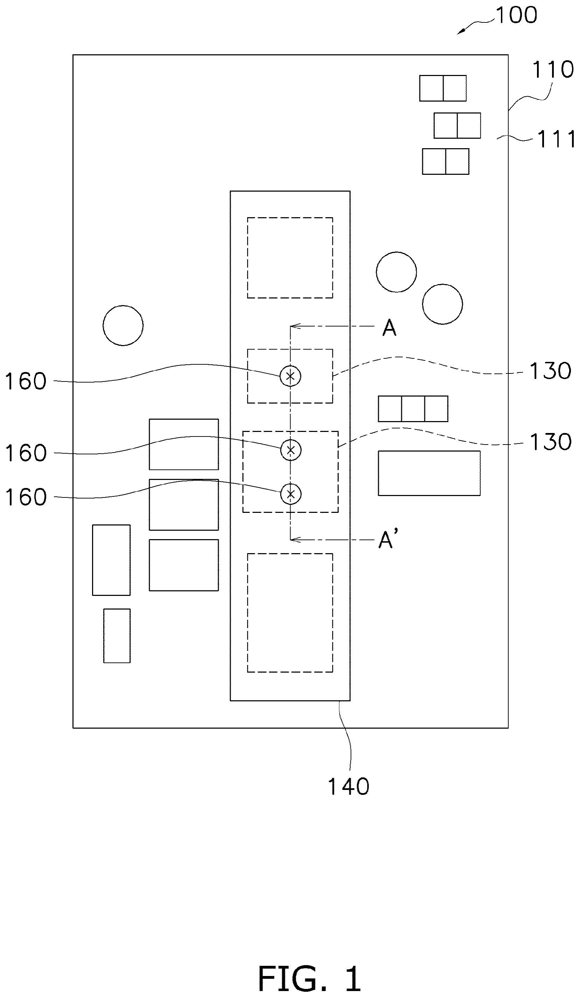

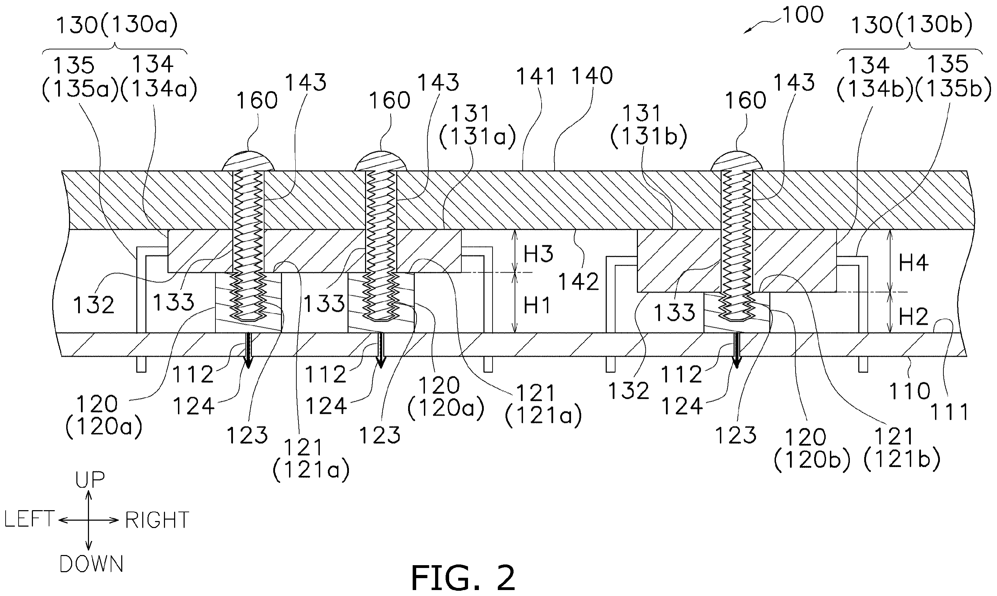

FIG. 1 is a schematic view of the electric component module 100, and FIG. 2 is a sectional view taken along line A-A 'in FIG. 1. The electric component module 100 includes a substrate 110, a first member 120 disposed on a mounting surface 111 of the substrate 110, a heat-generating component 130 mounted on the substrate 110, a heat sink 140 attached so as to be in contact with the heat-generating component 130, and a screw 160.

### (1-1) Substrate

The substrate 110 is an insulating plate-shaped member, and a conductive wiring pattern (not illustrated) is provided on its surface. A plurality of electronic components are mounted on the substrate 110, and the wiring pattern and the electronic components constitute an electric circuit. The electronic components include power modules, capacitors, reactors, and the like.

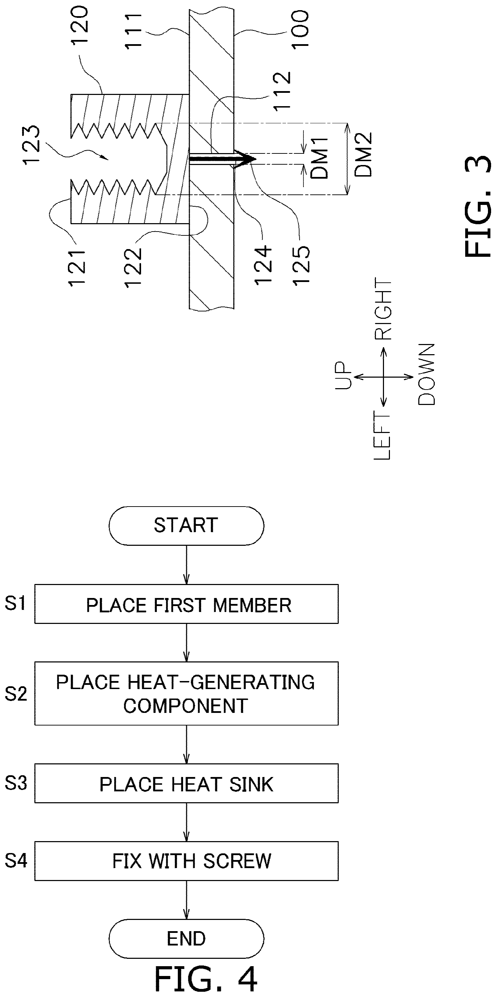

The substrate 110 has the mounting surface 111 on which the heat-generating component 130 is mounted. Note that an electronic component that does not generate heat during driving and an electronic component that generates less heat may be mounted on the mounting surface 111 or may be mounted on the surface on the opposite side to the mounting surface 111. Furthermore, a first hole 112 penetrating in the thickness direction is formed in the substrate 110. As illustrated in FIG. 3, a diameter DM1 of the first hole 112 is smaller than a diameter DM2 of the threaded hole of a screw receiver 123 to be described later, and is 2 mm or less. As described later, a positioner 124 of the first member 120 is inserted into the first hole 112.

### (1-2) First Member

The first member 120 is disposed between the mounting surface 111 of the substrate 110 and the heat sink 140, and is fixed to the mounting surface 111. FIG. 3 is a sectional view of the first member 120 disposed on the substrate 110. The first member 120 has the screw receiver 123 having a thread groove in a first surface 121 on the opposite side to a second surface 122 that faces the substrate 110 when the first member 120 is placed on the substrate 110. In the present embodiment, the screw receiver 123 is a threaded hole formed in the first surface 121. Note that the first surface 121 faces the heat sink 140. The height of the first member 120 is preferably 4 mm or more. In addition, the depth of the screw receiver 123 is preferably 2 mm or more. This configuration allows the screw 160 to be fixed to the screw receiver 123.

In addition, the first member 120 has, on the second surface 122, the positioner 124 for positioning the first member 120 with respect to the mounting surface 111. The positioner 124 is a rod-shaped body extending vertically from the second surface 122, and has a fitting part 125 at an end thereof. For example, the fitting part 125 may be a claw that snap-fits to the substrate 110. By inserting the rod-shaped body of the positioner 124 into the first hole 112 and hooking the fitting part 125 onto the substrate 110, the first member 120 is fixed to the substrate 110. As a result, the first member 120 is positioned with respect to the substrate 110. Note that since the first member 120 is made of a material having an insulating property, it is not necessary to consider the insulation distance.

### (1-3) Heat-Generating Component

The heat-generating component 130 is an electronic component that generates a large amount of heat when driven, such as a power module, a driver IC, a power transistor, or the like. In order for such electronic components to operate normally, the electronic components need to be cooled so that the electronic components do not exceed an operable temperature (for example, 90°C).

The heat-generating component 130 mainly includes a body part 134 and a plurality of leads 135. When mounted on the substrate 110, the body part 134 is located between the heat sink 140 and the substrate 110. An upper surface 131 (surface facing the heat sink 140) of the body part 134 is in contact with the heat sink 140 so as to have an appropriate heat transfer area. As a result, the heat-generating component 130 is thermally connected to the heat sink 140.

A third hole 133 for allowing passage of the screw 160 from the upper surface 131 toward a lower surface 132 (surface facing the substrate 110) is formed in the body part 134 of the heat-generating component 130. The third hole 133 is a through hole having no thread groove.

### (1-4) Heat Sink

The heat sink 140 is, for example, a member that is made of a metal having high thermal conductivity such as aluminum, is generally plate-shaped, and has a rectangular shape when viewed from the thickness direction. The heat sink 140 is a heat exchanger that cools the heat-generating component 130 by dissipating the heat absorbed from the heat-generating component 130 from the surface of the heat sink 140. The heat sink 140 is disposed so as to be thermally connected to the heat-generating component 130. In the present embodiment, the heat sink 140 is disposed so as to be in contact with the upper surface 131 of the body part 134 of the heat-generating component 130.

The heat sink 140 is formed with a screw hole 143 penetrating in the thickness direction from an upper surface 141 toward a lower surface 142 (surface facing the substrate 110) of the heat sink 140. The screw hole 143 is a through hole having no thread groove.

### (2) Detailed Configuration and Manufacturing Method of Electric Component Module

FIG. 4 is a flowchart illustrating a method for manufacturing the electric component module 100.

First, the first member 120 is placed on the mounting surface 111 of the substrate 110 (step S1). The first member 120 includes an eleventh member 120a and a twelfth member 120b. As illustrated in FIG. 2, height H1 of the eleventh member 120a is different from height H2 of the twelfth member 120b. The rod-shaped bodies of the positioners 124 of the eleventh member 120a and the twelfth member 120b are inserted into the first holes 112, and the fitting parts 125 are hooked on the substrate 110, so that the eleventh member 120a and the twelfth member 120b are positioned with respect to the mounting surface 111.

Next, the heat-generating component 130 is placed so as to be supported by the first member 120 (step S2). One heat-generating component 130 may be supported by one first member 120 or may be supported by a plurality of first members 120. The heat-generating component 130 includes a first heat-generating component 130a and a second heat-generating component 130b. The first heat-generating component 130a has a first body part 134a and a plurality of leads 135a extending from the first body part 134a. The second heat-generating component 130b has a second body part 134b and a plurality of leads 135b extending from the second body part 134b. The leads 135a and 135b are linear or plate-shaped conductive metals. In the present embodiment, the first body part 134a is disposed on two first surfaces 121a such that the first body part 134a is supported by the two eleventh members 120a. In addition, the second body part 134b is disposed on a single first surface 121b such that the second body part 134b is supported by the single twelfth member 120b.

The eleventh member 120a is configured such that, when the height H1 of the eleventh member 120a is combined with height H3 of the first body part 134a, the resulting height becomes substantially the same as the combined height of the height H2 of the twelfth member 120b and height H4 of the second body part 134b. Further, the twelfth member 120b is configured such that, when the height H2 of the twelfth member 120b is combined with the height H4 of the second body part 134b, the resulting height becomes substantially the same as the combined height of the height H1 of the eleventh member 120a and the height H3 of the first body part 134a. Therefore, by arranging the first body part 134a and the second body part 134b as described above, the height positions of the upper surface 131a (surface facing the heat sink 140) of the first body part 134a and the upper surface 131b (surface facing the heat sink 140) of the second body part 134b are aligned.

The leading ends of the leads 135a and 135b of the first heat-generating component 130a and the second heat-generating component 130b are then connected to substrate 110 using an electrical connection material such as solder, so that the first heat-generating component 130a and second heat-generating component 130b are mounted on the mounting surface 111.

Next, the heat sink 140 is placed so as to be in contact with the upper surfaces 131a and 131b of the first body part 134a and the second body part 134b (step S3). As described above, the height positions of the upper surfaces 131a and 131b of the first body part 134a and the second body part 134b, facing the heat sink 140, are aligned. Therefore, by placing the heat sink 140 such that the first body part 134a is sandwiched between the heat sink 140 and the first surfaces 121a of the two eleventh members 120a, and the second body part 134b is sandwiched between the heat sink 140 and the first surface 121b of the single twelfth member 120b, the heat sink 140 can be disposed so as to be in contact with the upper surfaces 131a and 131b of the first body part 134a and the second body part 134b. As described above, by thermally connecting the first heat-generating component 130a and the second heat-generating component 130b to the heat sink 140, heat generated in the first heat-generating component 130a and the second heat-generating component 130b can be dissipated via the heat sink 140.

Next, the screw 160 is inserted into the screw hole 143 from the upper surface 141 of the heat sink 140, and the screw 160 extending through the screw hole 143 and the third hole 133 in this order is inserted into the screw receiver 123 of the first member 120 and screwed into the thread groove. As a result, the screw 160 is fixed to the first member 120 (step S4).

### (3) Characteristics

(3-1)
The electric component module 100 according to the present embodiment includes the first heat-generating component 130a, the substrate 110, the heat sink 140, the first member 120, and the screw 160. The first heat-generating component 130a has the first body part 134a and the lead 135a extending from the first body part 134a. The substrate 110 has the mounting surface 111 on which the first heat-generating component 130a is mounted. The heat sink 140 is thermally connected to the first heat-generating component 130a. In addition, the heat sink 140 has the screw hole 143 penetrating in the thickness direction. The first member 120 is disposed between the mounting surface 111 and the heat sink 140 and fixed to the mounting surface 111. In addition, the first member 120 has the screw receiver 123. The screw 160 is inserted into the screw hole 143 from the upper surface 141 on the opposite side to the lower surface 142 of the heat sink 140 facing the mounting surface 111, and is fixed to the first member 120.

This configuration eliminates the need for a threaded hole in the substrate 110. As a result, the wiring of the substrate 110 can be easily routed. In addition, since the screw 160 extending through the heat sink 140 is fixed to the screw receiver 123 of the first member 120, it is possible to suppress the screw tip from coming into contact with the substrate 110.

(3-2)
In the electric component module 100 according to the present embodiment, the substrate 110 has the first hole 112 penetrating in the thickness direction. The first member 120 has the positioner 124 for positioning the first member 120 with respect to the mounting surface 111. The positioner 124 is inserted into the first hole 112.

This configuration allows the first member 120 to be positioned with respect to the substrate 110.

(3-3)
In the electric component module 100 according to the present embodiment, the first hole 112 has the diameter DM1 smaller than the diameter DM2 of the threaded hole of the screw receiver 123.

This configuration eliminates the need for a large hole in the substrate 110.

(3-4)
The electric component module 100 according to the present embodiment further includes the second heat-generating component 130b mounted on the mounting surface 111. The second heat-generating component 130b has the second body part 134b having a height different from the first body part 134a, and the lead 135b extending from the second body part 134b. The first member 120 includes the eleventh member 120a and the twelfth member 120b having different heights. The first body part 134a is supported by the eleventh member 120a and the second body part 134b is supported by the twelfth member 120b, so that the surfaces (upper surfaces 131a and 131b), facing the heat sink 140, of the first heat-generating component 130a and the second heat-generating component 130b mounted on the mounting surface 111 are positionally aligned.

This configuration allows an improvement in the cooling performance of the heat sink 140 for the heat-generating components 130 having different sizes.

### (4) Modifications

### (4-1) Modification 1A

The order and content of each processing in the flowchart described above can be appropriately changed without departing from the gist of the present disclosure.

### (4-2) Modification 1B

In the present embodiment, the positioner 124 is a rod-shaped body extending vertically from the second surface 122, and has the fitting part 125 at the end thereof. However, in some embodiments, the positioner 124 is a lead. The lead of the positioner 124 does not have to be fixed. By placing the heat-generating component 130 so as to be supported by the first member 120, when the heat-generating component 130 is fixed to the substrate 110, the position of the first member 120 with respect to the mounting surface 111 is also fixed.

Note that the lead of the positioner 124 may be fixed to the substrate 110 using solder. In this case, the position of the first member 120 with respect to the mounting surface 111 is more firmly fixed.

The present modification eliminates the need for a large hole in the substrate 110.

### (4-3) Modification 1C

The second surface 122 of the first member 120 may be surface-mounted on the mounting surface 111.

The present modification eliminates the need to provide a hole in the substrate 110 to fix the first member 120.

### (4-4) Modification 1D

The first member 120 may be made of metal.

### (4-5) Modification 1E

The outer contour of the first member 120 may be made of an insulating material, and the thread groove of the screw receiver 123 may be made of metal.

### (4-6) Modification 1F

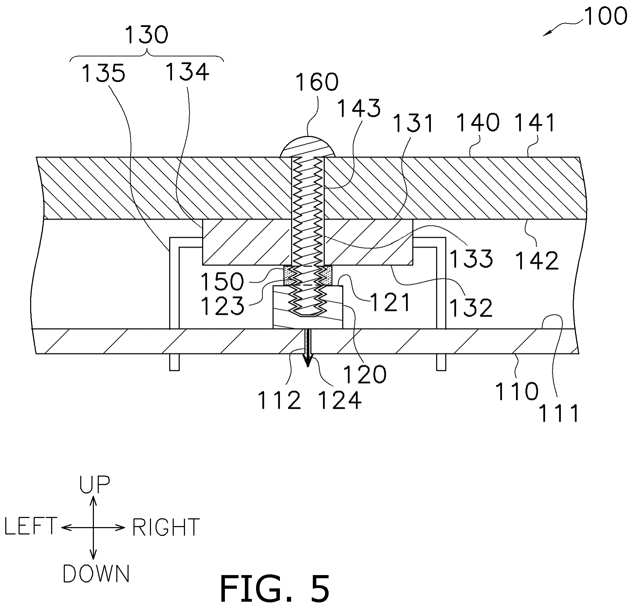

As illustrated in FIG. 5, the first member 120 may have a nut 150 serving as a component of the screw receiver 123. The nut 150 may be disposed between the first surface 121 and the body part 134. In this case, the first surface 121 does not have to have a threaded hole formed therein. The nut 150 is positioned such that the screw 160 inserted into the screw hole 143 from the upper surface 141 of the heat sink 140 can be screwed in. The screw 160 may be inserted into the screw hole 143 from the upper surface 141 of the heat sink 140, sequentially passed through the screw hole 143 and the third hole 133, and then screwed and fixed to the nut 150.

In the present modification, the height position of the upper surface 131 of the body part 134 can be adjusted by tightening the nut 150 toward the lower surface 132 of the body part 134 of the heat-generating component 130. As a result, even when mounting a plurality of heat-generating components 130 having the body parts 134 having different heights, it is not necessary to place the first member 120 in accordance with the height of each of the body parts 134, thereby enabling cost reduction.

### (4-7) Modification 1G

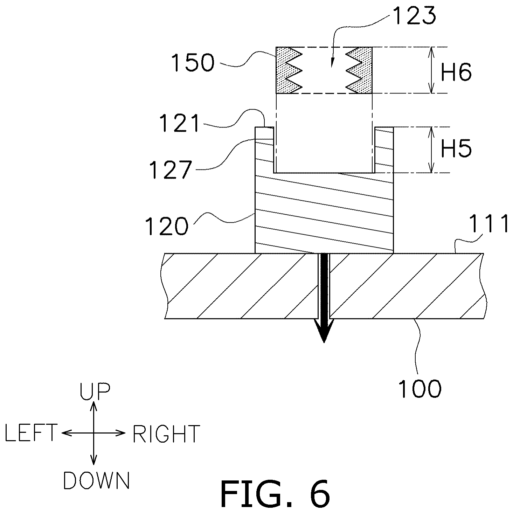

FIG. 6 is a sectional view of the first member 120. The first member 120 may have a recess 127 in the first surface 121 in which the nut 150 can be placed. In this case, the first surface 121 does not have to have a threaded hole formed therein. The nut 150 is disposed so as to be fitted in the recess 127. In addition, the nut 150 is positioned such that the screw 160 inserted into the screw hole 143 from the upper surface 141 of the heat sink 140 can be screwed in.

With the nut 150 positioned to fit into the recess 127, the position of the upper surface of the nut 150 is substantially the same as the position of the first surface 121. In other words, height H5 of the recess 127 is substantially the same as height H6 of the nut 150.

In the present modification, the placement position of the nut 150 can be stabilized. As a result, work efficiency is improved. The use of the nut 150 also allows for the common use of the first member 120. Specifically, the height position of the upper surface 131 of the body part 134 can be adjusted by tightening the nut 150 toward the lower surface 132 of the body part 134 of the heat-generating component 130. As a result, even when mounting a plurality of heat-generating components 130 having the body parts 134 having different heights, it is not necessary to place the first member 120 in accordance with the height of each of the body parts 134, thereby allowing for the common use of the first member 120.

### (4-8) Modification 1H

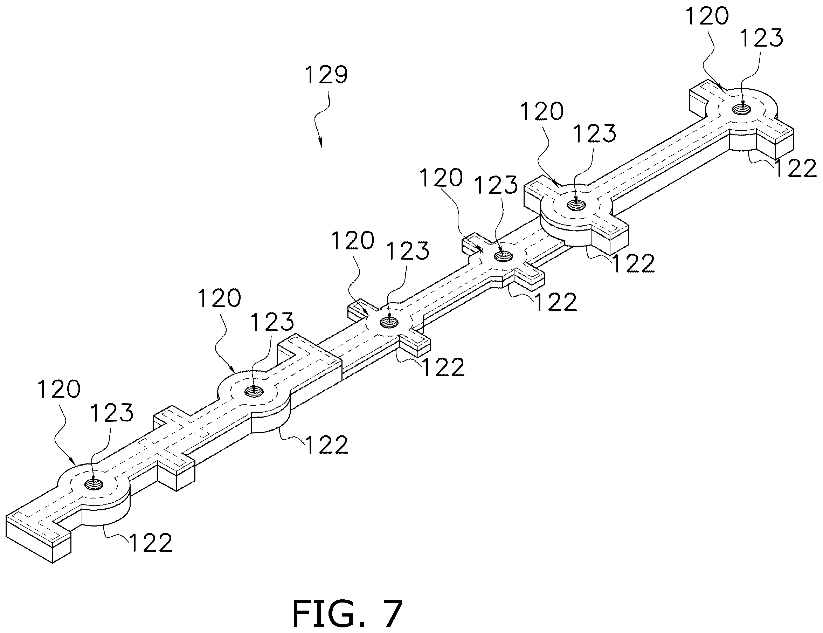

The plurality of first members 120 may be integrally molded. FIG. 7 illustrates an integrated member 129 in which six first members 120 having different heights are integrally molded. Note that the number of the first members 120 is not limited to this. The integrated member 129 may have a plurality of the positioners 124 for positioning the integrated member 129 with respect to the substrate 110. The positions of the positioners 124 are not limited to the second surface 122 of the first member 120, and may be any position on the surface of the integrated member 129 facing the substrate 110.

In the present modification, the plurality of first members 120 can be arranged at one time, thereby facilitating the arrangement of the first members 120.

### (4-9) Modification 1I

In Modification 1H, the plurality of first members 120 arranged in a straight line are integrally molded, but the first members 120 need not be arranged in a straight line.

### (4-10) Modification 1J

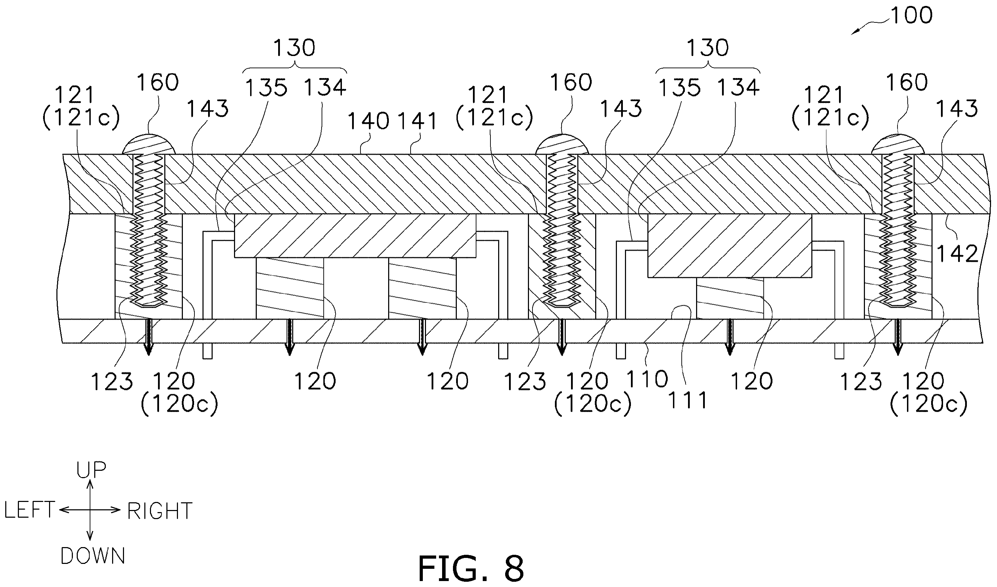

The first member 120 may include a thirteenth member 120c that does not support the heat-generating component 130. In this case, as illustrated in FIG. 8, the heat sink 140 may be disposed on a first surface 121c such that the heat sink 140 is supported by the first surface 121c of the thirteenth member 120c. The screw 160 may be inserted into the screw hole 143 from the upper surface 141 of the heat sink 140, and the screw 160 extending through the screw hole 143 may be inserted into the screw receiver 123 of the thirteenth member 120c and fixed to thirteenth member 120c.

In the present modification, it is not necessary to form the third hole 133 in the body part 134 of the heat-generating component 130. In addition, it is not necessary to form the screw receiver 123 in the first member 120 that supports the heat-generating component 130. As a result, the cost can be reduced.

### (4-11) Modification 1K

The nut 150 may be disposed between the first surface 121c of the thirteenth member 120c that does not support the heat-generating component 130 and the heat sink 140. In this case, the first surface 121c may further have the recess 127. The nut 150 may be disposed to fit into the recess 127.

### (4-12) Modification 1L

In the present embodiment, the third hole 133 for allowing passage of the screw 160 from the upper surface 131 toward the lower surface 132 (surface facing the substrate 110) is formed in the body part 134 of the heat-generating component 130. However, instead of the third hole 133, a first groove 136 into which the screw 160 can be fitted may be formed in the body part 134. The first groove 136 is formed from the upper surface 131 toward the lower surface 132 on one or more sides of the outer periphery of the body part 134 when viewed from the thickness direction of the body part 134. The first groove 136 has a cross section formed in a substantially arc shape or a substantially U-shape, and can be fitted with the screw 160. In this case, in step S4 in FIG. 4, the screw 160 may be inserted into the screw hole 143 from the upper surface 141 of the heat sink 140, and the screw 160 passed through the screw hole 143 and fitted into the first groove 136 may be inserted into the screw receiver 123 of the first member 120 and fixed.

### <Second Embodiment>

An air conditioner (refrigeration cycle apparatus) 1 including an electric component module 200 according to an embodiment of the present disclosure will be described with reference to the drawings. Note that in the following description, for convenience of explanation, expressions such as up, down, left, and right may be used to describe directions and positional relationships. The directions indicated by these expressions follow the directions indicated by the arrows in the drawings.

### (1) Configuration of Air Conditioner

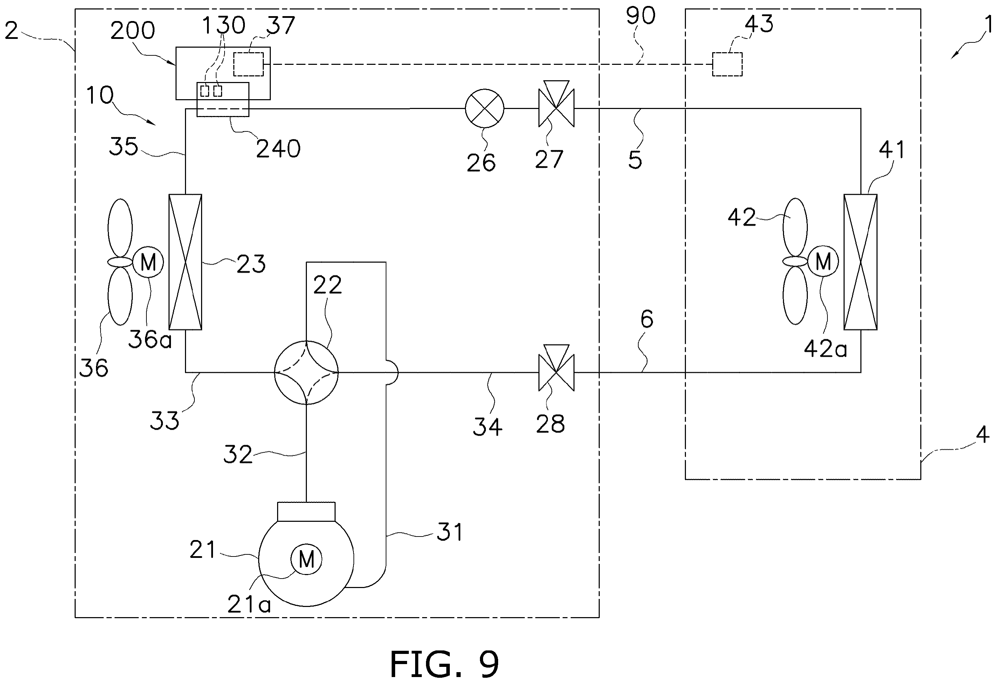

FIG. 9 is a schematic configuration diagram of the air conditioner 1. The air conditioner 1 is an apparatus that performs a vapor compression refrigeration cycle to cool and heat a space to be air-conditioned. However, the present invention is not limited thereto, and alternatively, the air conditioner 1 may be an apparatus that performs only one of cooling and heating. If the air conditioner 1 performs only one of cooling and heating, the air conditioner 1 does not have to have a four-way switching valve 22 described later.

Note that the refrigeration cycle apparatus according to the present disclosure is not limited to the air conditioner 1, and alternatively, the refrigeration cycle apparatus may be an apparatus that performs a vapor compression refrigeration cycle other than the air conditioner. For example, the refrigeration cycle apparatus according to the present disclosure may be a refrigeration cycle apparatus for a refrigerator or freezer used for preservation of food and the like, a hot water supply apparatus, or a floor heating apparatus, for example.

The air conditioner 1 includes an outdoor unit 2 and an indoor unit 4. The indoor unit 4 and the outdoor unit 2 are connected via a liquid-refrigerant connection pipe 5 and a gas-refrigerant connection pipe 6, to constitute a refrigerant circuit 10 that circulates a refrigerant therethrough. The refrigerant circuit 10 is filled with the refrigerant.

### (1-1) Outdoor Unit

The outdoor unit 2 is installed outdoors and constitutes part of the refrigerant circuit 10. The outdoor unit 2 mainly has a compressor 21, the four-way switching valve 22, an outdoor heat exchanger 23, an expansion valve 26, a liquid-side shutoff valve 27, a gas-side shutoff valve 28, an outdoor fan 36, an outdoor control unit 37, and a heat sink 240.

The compressor 21 is a device that compresses the sucked low-pressure refrigerant into a high-pressure refrigerant. The compressor 21 has a compressor motor 21a and a rotary or scroll compression element (not illustrated) that is rotationally driven in conjunction with the compressor motor 21a. In the compressor 21, a suction pipe 31 is connected to the suction side, and a discharge pipe 32 is connected to the discharge side. The suction pipe 31 is a refrigerant pipe that connects the suction side of the compressor 21 to the four-way switching valve 22. The discharge pipe 32 is a refrigerant pipe that connects the discharge side of the compressor 21 to the four-way switching valve 22.

The four-way switching valve 22 switches the flow direction of the refrigerant in the refrigerant circuit 10. The four-way switching valve 22 is connected to the suction pipe 31, the discharge pipe 32, a first gas refrigerant pipe 33, and a second gas refrigerant pipe 34. The first gas refrigerant pipe 33 connects the four-way switching valve 22 to the gas side of the outdoor heat exchanger 23. The second gas refrigerant pipe 34 connects the four-way switching valve 22 to the gas-side shutoff valve 28. During cooling operation, the four-way switching valve 22 switches the flow path so that the discharge pipe 32 and the first gas refrigerant pipe 33 are connected and the suction pipe 31 and the second gas refrigerant pipe 34 are connected (see the solid line of the four-way switching valve 22 in FIG. 9). Furthermore, during the heating operation, the four-way switching valve 22 switches the flow path so that the discharge pipe 32 and the second gas refrigerant pipe 34 are connected and the suction pipe 31 and the first gas refrigerant pipe 33 are connected (see the broken line of the four-way switching valve 22 in FIG. 9).

The outdoor heat exchanger 23 has one end connected to the first gas refrigerant pipe 33 and the other end connected to a liquid refrigerant pipe 35. The liquid refrigerant pipe 35 connects the liquid side of the outdoor heat exchanger 23 to the liquid-refrigerant connection pipe 5. The outdoor heat exchanger 23 is configured to allow heat exchange between the refrigerant and the outdoor air flow generated by the outdoor fan 36 during operation. The outdoor heat exchanger 23 functions as a condenser or radiator for the refrigerant during the cooling operation, and functions as an evaporator for the refrigerant during the heating operation.

The expansion valve 26 decompresses the high-pressure refrigerant. The expansion valve 26 is disposed on the liquid refrigerant pipe 35. During the cooling operation, the expansion valve 26 decompresses the high-pressure refrigerant that condenses or from which heat is released in the outdoor heat exchanger 23 to obtain a low-pressure refrigerant. Furthermore, during the heating operation, the expansion valve 26 decompresses the high-pressure refrigerant that condenses or from which heat is released in an indoor heat exchanger 41 to obtain a low-pressure refrigerant.

The heat sink 240 is a heat exchanger that cools the heat-generating component 130 by the refrigerant circulating in the refrigerant circuit 10. In the present embodiment, the heat-generating component 130 is cooled by the liquid refrigerant pipe 35. During the cooling operation, the heat sink 240 cools the heat-generating component 130 with the high-pressure refrigerant (that is, the refrigerant flowing between the outdoor heat exchanger 23 and the expansion valve 26) that condenses or from which heat is released in the outdoor heat exchanger 23. Furthermore, during the heating operation, the heat sink 240 cools the heat-generating component 130 with the low-pressure refrigerant (that is, the refrigerant flowing between the expansion valve 26 and the outdoor heat exchanger 23) decompressed by the expansion valve 26.

The outdoor fan 36 is, for example, a propeller fan. The outdoor fan 36 is connected to the output shaft of an outdoor fan motor 36a, and is driven in conjunction with the outdoor fan motor 36a. When driven, the outdoor fan 36 generates an outdoor air flow that flows into the outdoor unit 2, passes through the outdoor heat exchanger 23, and then flows out of the outdoor unit 2.

The outdoor control unit 37 is a microcomputer including a CPU, a memory, and the like. The outdoor control unit 37 controls the operation of each part of the outdoor unit 2. The outdoor control unit 37 is connected to an indoor control unit 43 via a dedicated line 90, and transmits and receives signals to and from the indoor control unit 43. Upon receiving a predetermined signal from the indoor control unit 43, the outdoor control unit 37 performs processing corresponding to the signal. The outdoor control unit 37 is included in the electric component module 200.

### (1-2) Indoor Unit

The indoor unit 4 is, for example, a so-called ceiling-embedded, ceiling-suspended, or wall-mounted indoor unit. The indoor unit 4 constitutes part of the refrigerant circuit 10. The indoor unit 4 mainly has the indoor heat exchanger 41, an indoor fan 42, and the indoor control unit 43.

The indoor heat exchanger 41 has one end connected to the liquid-refrigerant connection pipe 5 and the other end connected to the gas-refrigerant connection pipe 6. The indoor heat exchanger 41 is configured to allow heat exchange between the refrigerant and an indoor air flow generated by the indoor fan 42 during operation. The indoor heat exchanger 41 functions as an evaporator for the refrigerant during the cooling operation, and functions as a condenser or radiator for the refrigerant during the heating operation.

The indoor fan 42 is, for example, a propeller fan or a multiblade fan, and is connected to the output shaft of an indoor fan motor 42a. The indoor fan 42 is driven in conjunction with the indoor fan motor 42a. When driven, the indoor fan 42 generates an indoor air flow that flows into the indoor unit 4, passes through the indoor heat exchanger 41, and then flows out of the indoor unit 4.

The indoor control unit 43 is a microcomputer including a CPU, a memory, and the like. The indoor control unit 43 controls the operation of each part of the indoor unit 4. The indoor control unit 43 transmits and receives signals to and from the outdoor control unit 37 or a remote controller (not illustrated), and upon receiving a predetermined signal, performs processing corresponding to the signal.

### (2) Flow of Refrigerant in Refrigerant Circuit

### (2-1) Flow of Refrigerant During Cooling Operation

During the cooling operation, the four-way switching valve 22 is switched to a cooling cycle state (state indicated by the solid line in FIG. 9). When the compressor 21 is driven in this state, the low-pressure gas refrigerant is sucked into the compressor 21 and compressed into a high-pressure gas refrigerant. The high-pressure gas refrigerant discharged from the compressor 21 is sent to the outdoor heat exchanger 23 through the four-way switching valve 22. The high-pressure gas refrigerant sent to the outdoor heat exchanger 23 exchanges heat with the outdoor air flow generated by the outdoor fan 36 in the outdoor heat exchanger 23, and condenses into a high-pressure liquid refrigerant. The high-pressure liquid refrigerant condensed in the outdoor heat exchanger 23 is sent to the liquid refrigerant pipe 35.

The high-pressure liquid refrigerant sent to the liquid refrigerant pipe 35 exchanges heat with the heat-generating component 130 in the heat sink 240. At this time, the heat-generating component 130 is cooled in accordance with the flow rate (that is, the refrigerant circulation amount) and temperature of the refrigerant flowing through the liquid refrigerant pipe 35. As a result, during operation, the temperature of the heat-generating component 130 is prevented from rising beyond the operating temperature, which is the temperature range in which normal operation is possible. The high-pressure liquid refrigerant having exchanged heat with the heat-generating component 130 in the heat sink 240 is sent to the expansion valve 26.

The high-pressure liquid refrigerant sent to the expansion valve 26 is decompressed by the expansion valve 26 to become a low-pressure refrigerant in a gas-liquid two-phase state. The low-pressure refrigerant in the gas-liquid two-phase state decompressed by the expansion valve 26 is sent to the indoor heat exchanger 41 through the liquid-side shutoff valve 27 and the liquid-refrigerant connection pipe 5.

The low-pressure refrigerant in the gas-liquid two-phase state sent to the indoor heat exchanger 41 exchanges heat with the indoor air flow generated by the indoor fan 42 in the indoor heat exchanger 41, and evaporates into a low-pressure gas refrigerant. The low-pressure gas refrigerant evaporated in the indoor heat exchanger 41 is again sucked into the compressor 21 through the gas-refrigerant connection pipe 6, the gas-side shutoff valve 28, and the four-way switching valve 22.

### (2-2) Flow of Refrigerant During Heating Operation

During the heating operation, the four-way switching valve 22 is switched to a heating cycle state (state indicated by the broken line in FIG. 9). When the compressor 21 is driven in this state, the low-pressure gas refrigerant is sucked into the compressor 21 and compressed into a high-pressure gas refrigerant. The high-pressure gas refrigerant discharged from the compressor 21 is sent to the indoor heat exchanger 41 through the four-way switching valve 22, the gas-side shutoff valve 28, and the gas-refrigerant connection pipe 6. The high-pressure gas refrigerant sent to the indoor heat exchanger 41 exchanges heat with the indoor air flow generated by the indoor fan 42 in the indoor heat exchanger 41, and condenses into a high-pressure liquid refrigerant. The high-pressure liquid refrigerant condensed by the indoor heat exchanger 41 is sent to the expansion valve 26 through the liquid-refrigerant connection pipe 5 and the liquid-side shutoff valve 27. The high-pressure liquid refrigerant sent to the expansion valve 26 is decompressed by the expansion valve 26 to become a low-pressure refrigerant in a gas-liquid two-phase state. The low-pressure refrigerant in the gas-liquid two-phase state decompressed by the expansion valve 26 is sent to the liquid refrigerant pipe 35.

The low-pressure refrigerant in the gas-liquid two-phase state sent to the liquid refrigerant pipe 35 exchanges heat with the heat-generating component 130 in the heat sink 240. At this time, the heat-generating component 130 is cooled in accordance with the flow rate (that is, the refrigerant circulation amount) and temperature of the refrigerant flowing through the liquid refrigerant pipe 35. As a result, during operation, the temperature of the heat-generating component 130 is prevented from rising beyond the operating temperature, which is the temperature range in which normal operation is possible. The refrigerant in the gas-liquid two-phase state having exchanged heat with the heat-generating component 130 in the heat sink 240 is sent to the outdoor heat exchanger 23.

The low-pressure refrigerant in the gas-liquid two-phase state sent to the outdoor heat exchanger 23 exchanges heat with the outdoor air flow generated by the outdoor fan 36 in the outdoor heat exchanger 23, and evaporates into a low-pressure gas refrigerant. The low-pressure gas refrigerant evaporated in the outdoor heat exchanger 23 is again sucked into the compressor 21 through the four-way switching valve 22.

### (3) Detailed Configuration of Electric Component Module

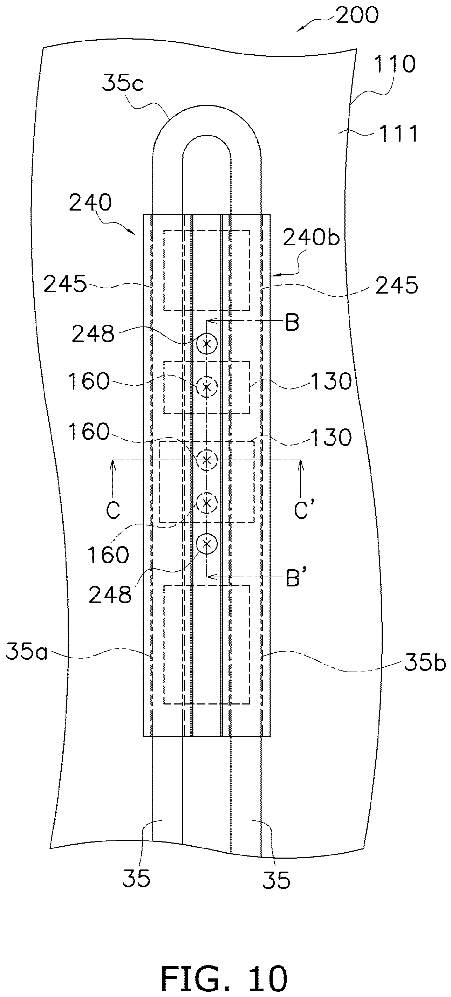

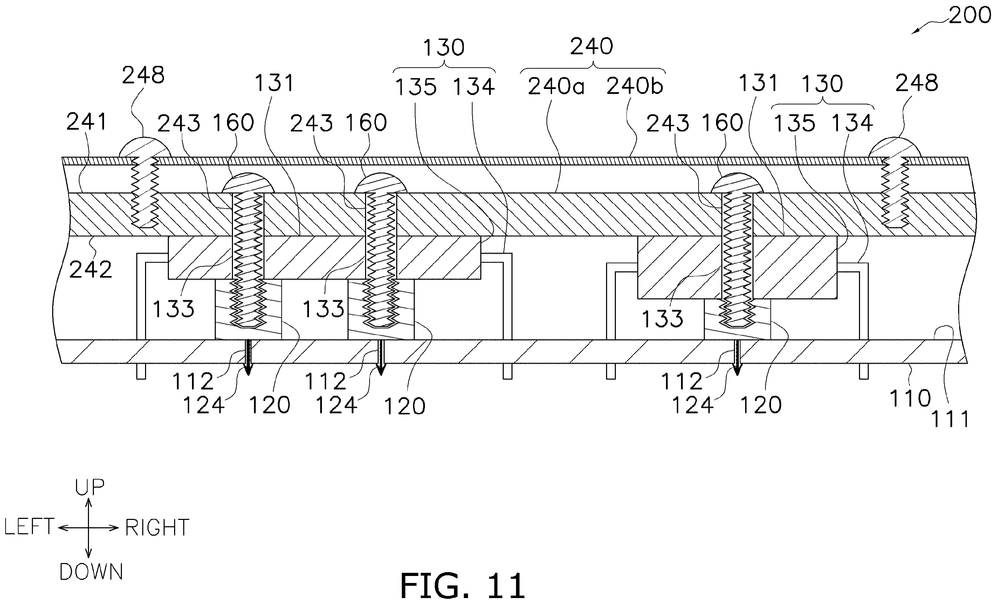

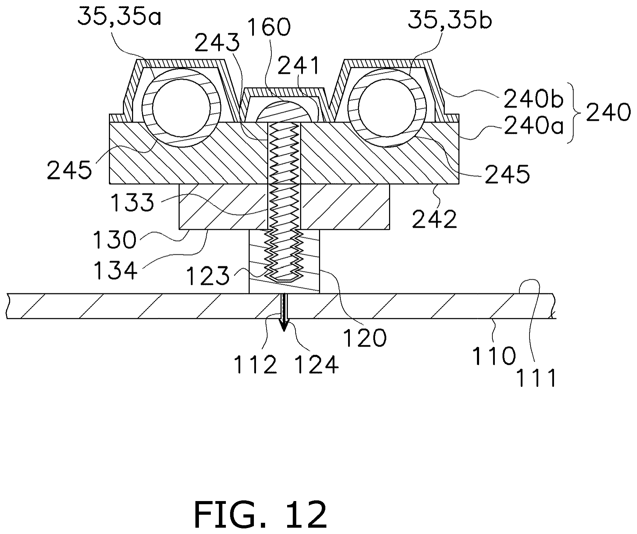

FIG. 10 is a schematic view of the electric component module 200, and FIG. 11 is a sectional view taken along line B-B 'in FIG. 10. FIG. 12 is a sectional view taken along line C-C' in FIG. 10. The electric component module 200 includes a plurality of electric components and electronic components for controlling the operation of the outdoor unit 2. The electric component module 200 includes the substrate 110, the first member 120 disposed on the mounting surface 111 of the substrate 110, the heat-generating component 130 mounted on the substrate 110, the heat sink 240 attached so as to be in contact with the heat-generating component 130, and the screw 160. Hereinafter, differences from the electric component module 100 according to the first embodiment will be mainly described.

### (3-1) Heat-Generating Component

The heat-generating component 130 is, for example, an inverter module that controls the operating frequency of the compressor motor 21a or an inverter module that controls the operating frequency of the outdoor fan motor 36a. In order for the air conditioner 1 to operate normally, it is necessary to perform cooling such that the heat-generating component 130 does not exceed an operable temperature (for example, 90°C).

### (3-2) Heat Sink

The heat sink 240 mainly has a heat sink body 240a and a cover 240b. The heat sink 240 is a heat exchanger that cools the heat-generating component 130 by dissipating the heat absorbed from the heat-generating component 130 from the surface of the heat sink 240.

The heat sink body 240a is, for example, a member that is made of a metal having high thermal conductivity such as aluminum, is generally plate-shaped, and has a rectangular shape when viewed from the thickness direction. The heat sink body 240a is disposed so as to be thermally connected to the heat-generating component 130. In the present embodiment, the heat sink body 240a is disposed so as to be in contact with the upper surface 131 of the body part 134 of the heat-generating component 130.

A first straight pipe part 35a and a second straight pipe part 35b, which are part of the liquid refrigerant pipe 35, are arranged on an upper surface 241 of the heat sink body 240a so as to be in contact with the heat sink body 240a. The first straight pipe part 35a and the second straight pipe part 35b are connected via a folded part 35c, and the first straight pipe part 35a, the folded part 35c, and the second straight pipe part 35b form a U-shape.

More specifically, as illustrated in FIGS. 10 and 12, the heat sink body 240a is formed with two second grooves 245 into which the first straight pipe part 35a and the second straight pipe part 35b can be fitted. Grease for promoting heat conduction is applied between the second groove 245 and each of the first straight pipe part 35a and the second straight pipe part 35b. The second groove 245 has a substantially arc-shaped cross section, into which the first straight pipe part 35a and the second straight pipe part 35b are fitted. This increases the contact area between the heat sink body 240a and each of the first straight pipe part 35a and the second straight pipe part 35b.

During the cooling operation, the high-pressure refrigerant (that is, the refrigerant flowing between the outdoor heat exchanger 23 and the expansion valve 26) that condenses or from which heat is released in the outdoor heat exchanger 23 flows through the liquid refrigerant pipe 35. Furthermore, during the heating operation, the low-pressure refrigerant (that is, the refrigerant flowing between the expansion valve 26 and the outdoor heat exchanger 23) decompressed by the expansion valve 26 flows through the refrigerant pipe.

As described above, by arranging the heat-generating component 130 in contact with the heat sink body 240a, and the heat sink body 240a in contact with the liquid refrigerant pipe 35, when the refrigerant flows through the liquid refrigerant pipe 35, the refrigerant flowing through the first straight pipe part 35a and the second straight pipe part 35b cools the heat-generating component 130 via the pipe walls of the first straight pipe part 35a and the second straight pipe part 35b, and the heat sink body 240a.

In addition, the heat sink body 240a is formed with a screw hole 243 that penetrates in the thickness direction from the upper surface 241 toward a lower surface 242 (surface facing the substrate 110) of the heat sink body 240a. The screw hole 243 is a through hole having no thread groove. The screw hole 243 is formed in the central part of the heat sink body 240a (more specifically, between one second groove 245 and the other second groove 245).

The cover 240b covers the heat sink body 240a, and the first straight pipe part 35a and second straight pipe part 35b of the liquid refrigerant pipe 35 attached to the heat sink body 240a. The cover 240b has a rectangular shape when viewed from the thickness direction of the heat sink body 240a. The cover 240b is fixed to the heat sink body 240a by, for example, a screw 248.

### (4) Characteristics

(4-1)
The air conditioner 1 according to the present embodiment includes the liquid refrigerant pipe 35 (first straight pipe part 35a and second straight pipe part 35b) through which the refrigerant flows, and one of the electric component modules 200 according to the first embodiment. The liquid refrigerant pipe 35 is in contact with the heat sink 240.

This configuration eliminates the need for a threaded hole in the substrate 110. As a result, the wiring of the substrate 110 can be easily routed. In addition, since the screw 160 extending through the heat sink 240 is fixed to the screw receiver 123 of the first member 120, it is possible to suppress the screw tip from coming into contact with the substrate 110.

### (5) Modifications

### (5-1) Modification 2A

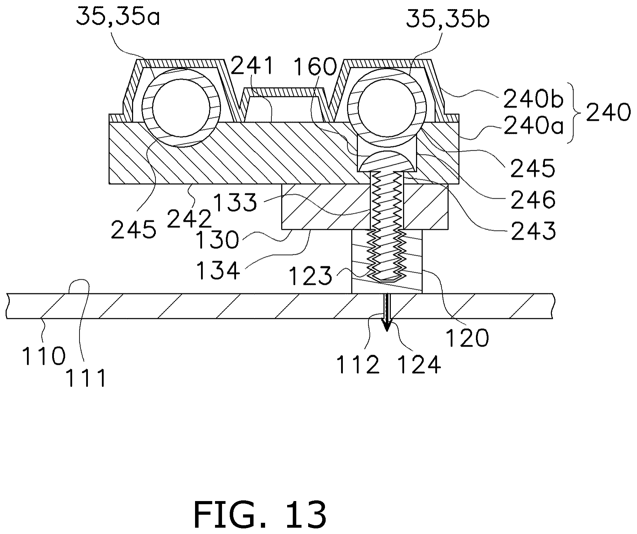

In the present embodiment, the screw hole 243 is formed in the central part of the heat sink body 240a (more specifically, between one second groove 245 and the other second groove 245). However, the screw hole 243 may be formed in the second groove 245. In this case, as illustrated in FIG. 13, a recess 246 is further formed in the second groove 245. The recess 246 is configured such that the screw head does not come into contact with the liquid refrigerant pipe 35 when the screw 160 is inserted into the screw hole 243 from the upper surface 241 of the heat sink 240 and the screw 160 extending through the screw hole 243 and the third hole 133 in this order is inserted into the screw receiver 123 of the first member 120 and fastened.

In the present modification, damage to the liquid refrigerant pipe 35 due to the screw head can be suppressed.

### (5-2) Modification 2B

In the present embodiment, the heat sink 240 has the heat sink body 240a and the cover 240b, and the first straight pipe part 35a and second straight pipe part 35b are arranged so as to be in contact with the upper surface 241 of the heat sink body 240a.

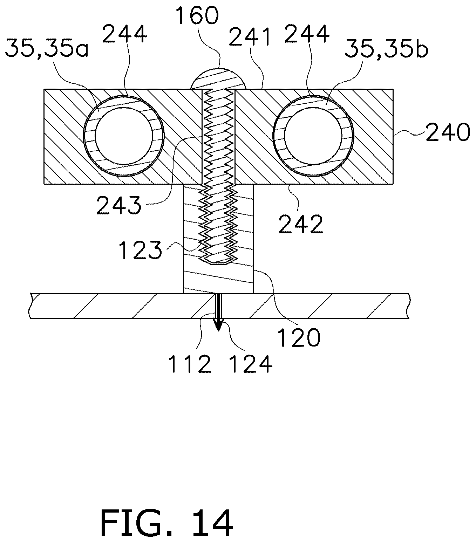

However, as illustrated in FIG. 14, the heat sink 240 may have a second hole 244 that allows passage of the first straight pipe part 35a and second straight pipe part 35b. The second hole 244 extends in the longitudinal direction of the heat sink 240, and the first straight pipe part 35a and second straight pipe part 35b may be joined to the heat sink 240 by being press-fitted into the second holes 244. In this case, the screw 160 may be inserted into the screw hole 243 from the upper surface 241 of the heat sink 240, and the screw 160 extending through the screw hole 243 may be inserted into and fastened to the screw receiver 123 of the first member 120.

In the present modification, the contact area between the heat sink 240 and each of the first straight pipe part 35a and second straight pipe part 35b is increased, thereby allowing an improvement in the cooling performance of the heat sink 240 for the heat-generating component 130. In addition, the need to attach a cover for the liquid refrigerant pipe 35 is eliminated, thereby allowing an improvement in installation work efficiency.

### (5-3) Modification 2C

The heat sink 240 and the liquid refrigerant pipe 35 (the first straight pipe part 35a and the second straight pipe part 35b, and the folded part 35c) may be joined by solder joining, brazing joining, caulking joining, or adhesive joining.

In the present modification, the contact area between the liquid refrigerant pipe 35 and the heat sink 240 is increased, thereby allowing an improvement in the cooling performance of the heat sink 240 for the heat-generating component 130. In addition, the need to attach a cover for the liquid refrigerant pipe 35 is eliminated, thereby allowing an improvement in installation work efficiency.

### (5-4) Modification 2D

Decompression means may be provided between the outdoor heat exchanger 23 and the heat sink 240. Thus, during the cooling operation, the refrigerant flowing through the liquid refrigerant pipe 35 (the first straight pipe part 35a and the second straight pipe part 35b) can be converted into the refrigerant having an intermediate pressure by the decompression means. As a result, the cooling performance of the heat sink 240 for the heat-generating component 130 can be improved.

The embodiments of the present disclosure have been described above. It is understood that various changes to modes and details should be available without departing from the gist and scope of the present disclosure recited in the claims.

### REFERENCE SIGNS LIST

1 air conditioner, refrigeration cycle apparatus
35 refrigerant pipe, liquid refrigerant pipe
35a refrigerant pipe, first straight pipe part
35b refrigerant pipe, second straight pipe part
100, 200electric component module
110 substrate
111 mounting surface
112 first hole
120 first member
120a first member, eleventh member
120b first member, twelfth member
120c first member, thirteenth member
121, 121a, 121b, 121c first surface
123 screw receiver
124 positioner
127 recess
130 heat-generating component
130a first heat-generating component
130b second heat-generating component
131, 131a, 131b surface, upper surface
134 body part
134a body part, first body part
134b body part, second body part
135, 135a, 135b lead
140, 240heat sink
141, 241surface, upper surface
142, 242surface, lower surface
143, 243screw hole
150 nut
160 screw
244 second hole

### CITATION LIST

### PATENT LITERATURE

Patent Literature 1: WO 2009/150804 A

## Claims

1. An electric component module (100, 200) comprising:
a first heat-generating component (130, 130a) having a first body part (134, 134a) and a lead (135, 135a) extending from the first body part;
a substrate (110) having a mounting surface (111) on which the first heat-generating component is mounted;
a heat sink (140, 240) thermally connected to the first heat-generating component and having a screw hole (143, 243) that penetrates in a thickness direction;
a first member (120, 120a, 120b, 120c) disposed between the mounting surface and the heat sink and fixed to the mounting surface, the first member having a screw receiver (123); and
a screw (160) that is inserted into the screw hole from a surface (141, 241) on a side opposite to a surface (142, 242) of the heat sink facing the mounting surface, and is fixed to the first member.

2. The electric component module according to claim 1, wherein
the substrate has a first hole (112) penetrating in the thickness direction, and
the first member has a positioner (124) for positioning the first member with respect to the mounting surface, the positioner being inserted into the first hole.

3. The electric component module according to claim 2, wherein the first hole has a diameter smaller than a diameter of a threaded hole of the screw receiver.

4. The electric component module according to any one of claims 1 to 3, wherein the first member further has a nut (150) serving as a component of the screw receiver.

5. The electric component module according to claim 4, wherein the first member further has a recess (127) in a first surface (121, 121a, 121b, 121c) facing the heat sink, the recess being configured to accommodate the nut.

6. The electric component module according to any one of claims 1 to 5, further comprising a second heat-generating component (130, 130b) mounted on the mounting surface, wherein
the second heat-generating component has a second body part (134, 134b) having a height different from the first body part, and a lead (135, 135b) extending from the second body part,
the first member includes an eleventh member (120, 120a) and a twelfth member (120, 120b) having different heights, and
the first body part is supported by the eleventh member and the second body part is supported by the twelfth member, so that surfaces (131, 131a, 131b), facing the heat sink, of the first heat-generating component and the second heat-generating component mounted on the mounting surface are positionally aligned.

7. The electric component module according to any one of claims 1 to 6, wherein a plurality of the first members are integrally molded.

8. A refrigeration cycle apparatus (1) comprising:
a refrigerant pipe (35, 35a, 35b) through which a refrigerant flows; and
the electric component module (200) according to any one of claims 1 to 7, wherein
the refrigerant pipe is in contact with the heat sink.

9. The refrigeration cycle apparatus according to claim 8, wherein
the heat sink has a second hole (244) that allows passage of the refrigerant pipe, and
the refrigerant pipe extending through the second hole is joined to the heat sink.

10. A method for manufacturing an electric component module, comprising:
a first step of placing a first member (120, 120a, 120b, 120c) having a screw receiver (123) on a mounting surface (111) of a substrate (110), the mounting surface (111) being for mounting a first heat-generating component (130, 130a), the first heat-generating component having a first body part (134, 134a) and a lead (135, 135a) extending from the first body part;
a second step of mounting the first heat-generating component on the mounting surface;
a third step of placing a heat sink (140, 240) in such a manner that the heat sink is thermally connected to the first heat-generating component, the heat sink having a screw hole (143, 243) penetrating in a thickness direction; and
a fourth step of inserting a screw (160) into the screw hole from a surface (141, 241) on a side opposite to a surface (142, 242) of the heat sink facing the mounting surface, and fixing the screw to the first member.
